# EUROPEAN PATENT SPECIFICATION

(11) **EP 3 823 017 B1**
(45) Date of publication and mention of the grant of the patent: **07.12.2022**
(21) Application number: 19834027.5
(22) Date of filing: 11.07.2019
(51) Int. Cl.: H01L 23/373, C22C 1/10, B32B 9/00, B32B 5/02, B32B 5/24, B32B 15/04, B32B 15/14, B32B 15/20, C04B 41/00, C04B 41/51, C04B 41/88, C22C 29/06, C04B 111/00

(54) **METAL-SILICON CARBIDE-BASED COMPOSITE MATERIAL, AND METHOD FOR PRODUCING METAL-SILICON CARBIDE-BASED COMPOSITE MATERIAL**
VERBUNDWERKSTOFF AUF DER BASIS VON METALL-SILICIUMCARBID UND VERFAHREN ZUR HERSTELLUNG EINES VERBUNDWERKSTOFFES AUF DER BASIS VON METALL-SILICIUMCARBID
MATÉRIAU COMPOSITE À BASE DE CARBURE DE MÉTAL-SILICIUM ET PROCÉDÉ DE PRODUCTION DE MATÉRIAU COMPOSITE À BASE DE CARBURE DE MÉTAL-SILICIUM

(30) Priority: 13.07.2018 JP 2018132807
(43) Date of publication of application: 19.05.2021
(73) Proprietor: Denka Company Limited, Tokyo 103-8338 (JP)
(72) Inventor: GOTO, Daisuke, Omuta-city, Fukuoka 836-8510 (JP); OTA, Hiroaki, Omuta-city, Fukuoka 836-8510 (JP)
(74) Representative: Gulde & Partner
(86) International application number: PCT/JP2019/027600
(87) International publication number: WO 2020/013300

(56) References cited:
- EP-A1- 2 012 354
- WO-A1-2007/125878

## Description

### Technical Field

The present disclosure relates to a metal-silicon carbide-based composite material, and a method for producing a metal-silicon carbide-based composite material. Particularly, the present disclosure relates to a highly heat conductive metal-silicon carbide-based composite material that is excellent in heat conductive characteristics, is light in weight, and is suitable for a heat radiation body such as a heat sink that is used in a semiconductor component such as a ceramic substrate and an IC package, and a method for producing the same.

### Background Art

As a heat sink for power modules, typically, a metal such as copper, aluminum, Cu-Mo, and Cu-W, ceramics such as AlN, Si₃N₄, and Al₂O₃, a composite material of a metal and ceramics such as Al-SiC, and the like are used. Examples of a metal-silicon carbide-based composite material that is used as the heat sink for power modules include an aluminum alloy-silicon carbide-based composite material described in Patent Literature 1, and a composite material of magnesium or a magnesium alloy and silicon carbide described in Patent Literature 2. The composite materials disclosed in the literatures are light in weight, have high heat conductivity, and a coefficient thermal expansion close to that of constituent components of modules such as a semiconductor element, and are suitable as a heat sink for power modules.
Patent Literature 3 discloses a base plate for power modules comprising an aluminum-silicon carbide composite material and aluminum layers formed on respective principal planes of the aluminum-silicon carbide composite.

Patent Literature 4 discloses an aluminum silicon carbide composite that is suitable as a power module base plate.

### Citation List

### Patent Literature

Patent Literature 1: JP 2017-39997 A
Patent Literature 2: JP 2013-245374 A
Patent Literature 3: EP 2 012 354 A1
Patent Literature 4: WO 2007/125878 A1

### Summary of Invention

### Technical Problem

Typically, a ceramic circuit substrate is soldered to a surface of the heat sink for power modules. From the viewpoint of improving affinity for solder, a surface of the metal-silicon carbide-based composite material is typically covered with a metal layer.

Due to the metal layer that covers front and rear surfaces of the metal-silicon carbide-based composite material, the composite material is provided with a plurality of layers having coefficients of thermal expansion different from each other, and this results in a structure imitating a bimetal. In a case where coefficients of thermal expansion of respective layers are different from each other, a thermal stress occurs due to a heat cycle exposed to a high temperature and a low temperature. At this time, the larger a thickness difference between the metal layers on the front and rear surfaces is, the greater the difference in the thermal stress is, and thus a variation in bow occurs in the metal-silicon carbide-based composite material due to a heat cycle. When the variation in bow occurs, a gap occurs between the heat sink and cooling fins, and thus heat radiation characteristics greatly deteriorate. According to this, it is preferable that the thicknesses of the metal layers on the front and rear surfaces are uniform or have no difference.

Here, the thicknesses of the metal layers (hereinafter, referred to as "surface layer") formed on the front and rear surfaces of the metal-silicon carbide-based composite material greatly depend on a surface state of a silicon carbide-based porous body before being infiltrated with a metal. Since surface accuracy of the silicon carbide-based porous body has an influence on thickness or surface roughness when being composited, facing processing is frequently performed. However, even in the case of performing the facing processing, it is difficult to sufficiently reduce a thickness difference of the metal layers on the front and rear surfaces.

The present disclosure has been made in consideration of the above-described circumstances, and an object thereof is to provide a metal-silicon carbide-based composite material in which a thickness difference between surface layers formed on front and rear surfaces of a silicon carbide-based porous body is small and the amount of variation in bow is small even undergoing a heat cycle while having heat conductivity and a coefficient of thermal expansion to a certain extent as in the related art, and a method capable of producing the metal-silicon carbide-based composite material at low cost.

### Solution to Problem

According to an aspect of the present disclosure, there is provided a metal-silicon carbide-based composite material including: a composite part including a silicon carbide-based porous body constituted by a plurality of silicon carbide particles, and a metal that is infiltrated in the silicon carbide-based porous body; and first and second surface layers which contain a metal, and coat both main surfaces of the composite part. The metal contains at least one kind selected from the group consisting of aluminum and magnesium, and the amount of particles having a particle size of 300 µm or more in the plurality of silicon carbide particles is 5% by volume or less.

According to another aspect of the present disclosure, there is provided a method for producing the metal-silicon carbide-based composite material. The method includes: a classification process of classifying a silicon carbide powder to obtain a classified powder in which silicon carbide having a particle size of 300 µm or more is 5% by volume or less; a molding process of pressure-molding a mixture prepared by mixing silica sol to the classified powder to obtain a green compact; a calcination process of heating the green compact at 800°C to 1100°C in the air or in an inert gas atmosphere to obtain a silicon carbide-based porous body; a facing processing process of performing facing processing on the silicon carbide-based porous body with a diamond processing jig; and an infiltration process of infiltrating the silicon carbide-based porous body that is facing-processed with a molten metal, and cooling the resultant silicon carbide-based porous body to form a composite part including the silicon carbide-based porous body and a metal that is infiltrated in the silicon carbide-based porous body, and first and second surface layers which contain metal and coat both main surfaces of the composite part.

### Advantageous Effects of Invention

According to the present disclosure, it is possible to provide a metal-silicon carbide-based composite material in which a thickness difference between surface layers formed on front and rear surfaces of a silicon carbide-based porous body is small and the amount of variation in bow is small even undergoing a heat cycle while having heat conductivity and a coefficient of thermal expansion to a certain extent as in the related art. In addition, according to the present disclosure, it is possible to provide a method capable of producing the metal-silicon carbide-based composite material at low cost.

### Brief Description of Drawings

FIG. 1 is a cross-sectional view illustrating an example of a metal-silicon carbide-based composite material.
FIG. 2 is a schematic view for describing an effect of the metal-silicon carbide-based composite material according to the present disclosure.
FIG. 3 is a schematic view for describing a method for measuring the thickness of first and second surface layers of the metal-silicon carbide-based composite material.
FIG. 4 is a schematic view for describing a method for measuring the amount of bow of the metal-silicon carbide-based composite material.
FIG. 5 is a cross-section photograph showing of a part of an example of the metal-silicon carbide-based composite material.

### Description of Embodiments

Hereinafter, description will be given of a metal-silicon carbide-based composite material and a method for producing the same according to the present disclosure with reference to the accompanying drawings. Note that, the present disclosure is not limited to the following embodiment. In addition, it is assumed that a positional relationship such as up, down, right, and left is based on a positional relationship illustrated in the drawings unless otherwise stated. In addition, a dimension ratio of respective elements is not limited to a ratio illustrated in the drawings.

### [Definition]

In the following description, it is assumed that description of "to" represents "or more" and "or less", and a numerical value range described in "to" includes an upper limit value and a lower limit value thereof. For example, "A to B" represents A or more and B or less. In addition, a "main surface" represents any one surface between an upper surface and a lower surface of an object formed in a flat plate.

### [Metal-Silicon Carbide-Based Composite Material]

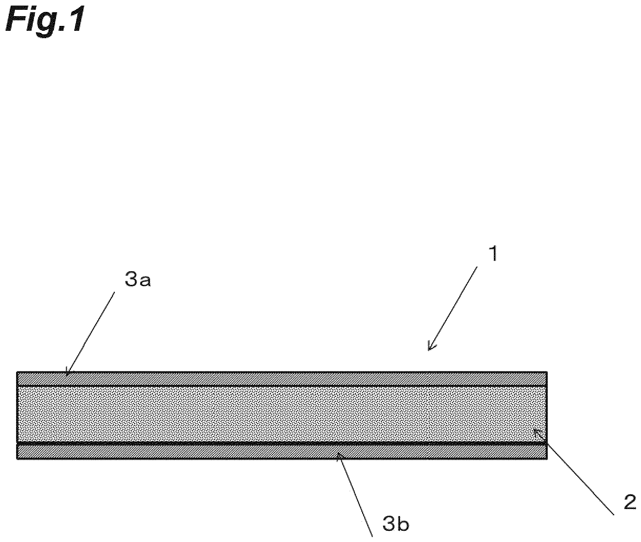

An embodiment of a metal-silicon carbide-based composite material will be described. FIG. 1 is a cross-sectional view illustrating an example of the metal-silicon carbide-based composite material. A metal-silicon carbide-based composite material 1 includes a composite part 2, a first surface layer 3a provided on one main surface of the composite part 2, and a second surface layer 3b provided on the other main surface of the composite part 2.

The metal-silicon carbide-based composite material 1 is, for example, a metal-silicon carbide-based composite material 1 including a composite part 2 formed by infiltrating a silicon carbide-based porous body constituted by silicon carbide particles with a metal containing one or more of aluminum and magnesium as a main component, and both main surfaces of the composite part 2 are coated with surface layers (the first surface layer 3a and the second surface layer 3b) containing a metal that contains one or more of aluminum and magnesium as a main component. The amount of particles having a particle size of 300 µm or greater is 5% by volume or less with respect to the silicon carbide particles contained in the composite part 2. Note that, the metal-silicon carbide-based composite material 1 illustrated in FIG. 1 has a flat plate shape.

In the metal-silicon carbide-based composite material 1, with regard to the surface layers (the first surface layer 3a and the second surface layer 3b) which coat both main surfaces of the composite part 2, a thickness difference between a front side and a rear side may be within 50 µm.

In the metal-silicon carbide-based composite material 1, the amount of variation in bow when carrying out a heat cycle test can be set within ±50%.

The metal-silicon carbide-based composite material 1 having the above-described configuration has high heat conductivity and a coefficient of thermal expansion close to that of a semiconductor element, and the thickness difference between the surface layers on both main surfaces of the composite part 2 is reduced, and bow stability at the time of heat cycle is excellent.

### [Silicon Carbide Particles]

The silicon carbide-based porous body that constitutes the composite part 2 of the metal-silicon carbide-based composite material 1 includes silicon carbide particles. The amount of the silicon carbide component of the silicon carbide particles constituting the silicon carbide-based porous body of the composite part 2 corresponds to the amount of silicon carbide component of silicon carbide powder when preparing the silicon carbide-based porous body, and is preferably 90% by mass or greater, more preferably 95% by mass or greater, and still more preferably 99% by mass or greater. In addition, the upper limit may be 100% by mass.

In the silicon carbide powder (SiC powder), it is preferable that silicon carbide particles which constitute the powder is highly heat conductive. The silicon carbide component of the silicon carbide powder may have high purity of preferably 90% by mass or greater, more preferably 95% by mass or greater, and still more preferably 99% by mass or greater. As the silicon carbide powder, typically, it is preferable to use a silicon carbide powder exhibiting "a green color". The upper limit of the silicon carbide component of the silicon carbide particles may be 100% by mass.

A filling rate of the silicon carbide particles occupied in the silicon carbide-based porous body, that is, a filing rate of the silicon carbide powder of the raw material is, for example, preferably 50% by volume to 80% by volume, and more preferably 60% by volume to 75% by volume. More specifically, a lower limit value of the amount of the silicon carbide particles contained in the silicon carbide-based porous body is, for example, 50% by volume or greater, 55% by volume or greater, or 60% by volume greater. An upper limit value of the amount of the silicon carbide particles contained in the silicon carbide-based porous body is, for example, 80% by volume or less, 75% by volume or less, or 70% by volume or less. In order to increase the filling rate of the silicon carbide of the porous body, that is, the amount of the silicon carbide contained in the silicon carbide-based porous body, the silicon carbide powder may have an appropriate particle size distribution, and for this purpose, as the silicon carbide powder, a material obtained by appropriately blending two or more kinds of powders may be used.

A particle size of the silicon carbide particles constituting the silicon carbide-based porous body is not particularly limited, but it is preferable to include a plurality of silicon carbide particles having particle sizes different from each other from the viewpoint of improving heat conductivity. That is, the particle size of the silicon carbide powder is not particularly limited, but it is preferable that the silicon carbide particles constituting the silicon carbide-based porous body include silicon carbide particles having a particle size of equal to or greater than 1 µm to less than 50 µm, and silicon carbide particles having a particle size of equal to or greater than 100 µm and less than 300 µm from the viewpoint of heat conductivity.

In the silicon carbide particles constituting the silicon carbide-based porous body, it is preferable that silicon carbide particles having a particle size of equal to or greater than 1 µm and less than 50 µm and silicon carbide particles having a particle size of equal to or greater than 100 µm and less than 300 µm are main particles. Specifically, when a silicon carbide particle portion of the silicon carbide-based porous body is set as 100% by volume, a lower limit value of a total amount of the two kinds of silicon carbide particles contained may be, for example, 70% by volume or greater, 75% by volume or greater, 80% by volume or greater, 85% by volume or greater, or 90% by volume or greater. An upper limit value of the total amount may be 100% by volume or less, 99% by volume or less, or 98% by volume or less.

In the silicon carbide particles constituting the silicon carbide-based porous body, lower limit values of the amount of silicon carbide particles having a particle size of equal to or greater than 1 µm and less than 50 µm, and the amount of silicon carbide particles having a particle size of equal to or greater than 100 µm and less than 300 µm may be 10% by volume or greater, 15% by volume or greater, or 20% by volume or greater, respectively. Upper limit values of the amount of silicon carbide particles having a particle size of equal to or greater than 1 µm and less than 50 µm, and the amount of silicon carbide particles having a particle size of equal to or greater than 100 µm and less than 300 µm may be 80% by volume or less, 75% by volume or less, or 70% by volume or less, respectively.

With regard to the silicon carbide particles constituting the silicon carbide-based porous body, in addition to the silicon carbide particles having a particle size of equal to or greater than 1 µm and less than 50 µm, and the silicon carbide particles having a particle size of equal to or greater than 100 µm and less than 300 µm, examples of other silicon carbide particles include silicon carbide particles having a particle size of equal to or greater than 300 µm, silicon carbide particles having a particle size of equal to or greater than 50 µm and less than 100 µm, and silicon carbide particles having a particle size of less than 1 µm.

The amount of the other silicon carbide particles contained may be, for example, within the following ranges. The amount of the silicon carbide particles having a particle size of 300 µm or greater is one of characteristics of the metal-silicon carbide-based composite material according to the present disclosure, and will be described later. An upper limit value of the amount of the silicon carbide particles having a particle size of equal to or greater than 50 µm and less than 100 µm may be, for example, 15% by volume or less, 10% by volume or less, 5% by volume or less, or 3% by volume or less, and a lower limit value thereof may be, for example, 0% by volume or greater, 1% by volume or greater, or 2% by volume or greater. An upper limit value of the amount of the silicon carbide particles having a particle size of less than 1 µm may be, for example, 15% by volume or less, 10% by volume or less, 5% by volume or less, or 3% by volume or less, and a lower limit value thereof may be, for example, 0% by volume or greater, 1% by volume or greater, or 2% by volume or greater.

The metal-silicon carbide-based composite material of the present disclosure has a characteristic that the amount of silicon carbide particles having a particle size of 300 µm is 5% by volume or less in the silicon carbide particles contained in the silicon carbide-based porous body of the metal-silicon carbide-based composite material. The upper limit value of the amount of the silicon carbide particles having a particle size of 300 µm or greater is preferably 4% by volume or less, or 3% by volume or less. The lower limit value of the amount of the silicon carbide particles having a particle size of 300 µm or greater may be, for example, 0% by volume or greater or 1% by volume or greater. The upper limit values and the lower limit values can be achieved by setting the amount of the silicon carbide particles having a particle size of 300 µm or greater to 5% by volume or less through an operation such as classification with respect to the silicon carbide powder that is used as a raw material. Note that, a maximum value of a particle size in the particles having a particle size of 300 µm or greater is often 500 µm.

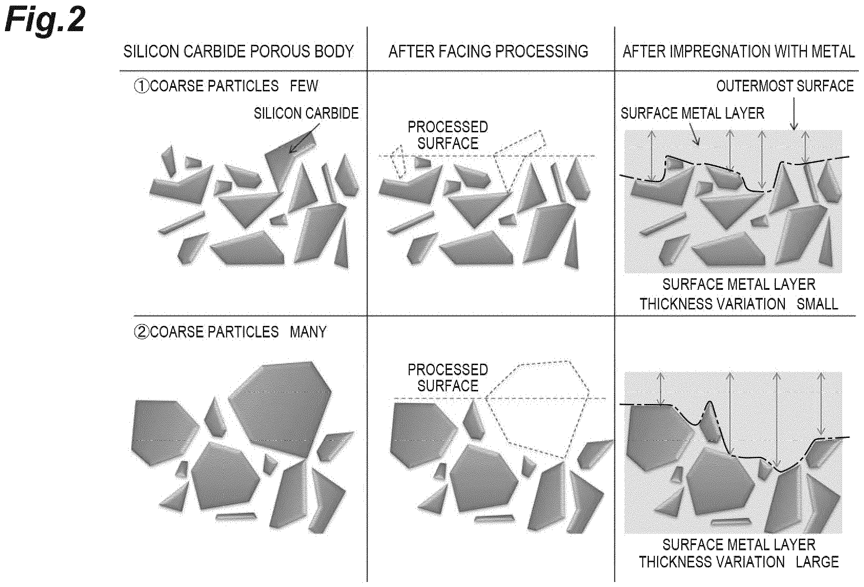

In a case where the amount of the silicon carbide particles having a particle size of 300 µm or greater exceeds 5% by volume, unevenness on a surface of the silicon carbide-based porous body becomes large. The reason for this is because hardness of silicon carbide is high, and thus when performing facing processing on the silicon carbide-based porous body, a site where coarse particles remain becomes convex, and a site processed in order for particles to be excluded from the silicon carbide-based porous body becomes concave as illustrated in FIG. 2. On the other hand, in a case where the amount of particles having a particle size of 300 µm or greater is 5% by volume or less, unevenness on the surface of the silicon carbide-based porous body can be reduced. The unevenness on the surface of the silicon carbide-based porous body has a great influence on the thickness of the surface layers (the first surface layer 3a and the second surface layer 3b, and a surface metal layer in FIG. 2) formed on front and rear surfaces of the composite part 2 after being infiltrated with a metal. For example, the thickness of the surface metal layer represents a thickness from an outermost surface of the surface metal layer to a position indicated by a one-dot chain line in a schematic view after metal infiltration in FIG. 2. The smaller the unevenness is, the further a thickness difference between the surface layers (the first surface layer 3a and the second surface layer 3b) formed on the front and rear surfaces of the composite part 2 can be reduced. As described above, the greater the thickness difference between the front and rear surface layers of the composite part 2 is, the greater a difference in coefficient of thermal expansion between respective layers is, and thus a thermal stress occurs due to a heat cycle, and a variation in bow occurs. When the variation in bow occurs, a bow shape varies. In the case of using a metal-silicon carbide-based composite material in which the variation in bow is large, that is, a variation in a bow shape is large as a heat sink for power modules, a gap with cooling fins occurs after a heat cycle test, and heat radiation characteristics greatly deteriorate. From the above-described reason, it is preferable that the thickness of the surface layers (the first surface layer 3a and the second surface layer 3b) of the metal-silicon carbide-based composite material is uniform or has no difference between front and rear surfaces.

The amount of the silicon carbide particles contained in the metal-silicon carbide-based composite material 1 is preferably 50% by volume to 80% by volume, and more preferably 60% by volume to 70% by volume. When the amount of the silicon carbide particles contained in the metal-silicon carbide-based composite material 1 is 50% by volume or greater, heat conductivity of the metal-silicon carbide-based composite material that is obtained can be sufficiently secured. In addition, from the viewpoint of a filling property, the amount of the silicon carbide particles contained in the metal-silicon carbide-based composite material 1 is preferably 80% by volume or less. When the amount of the silicon carbide particles contained in the metal-silicon carbide-based composite material 1 is 80% by volume or less, the shape of the silicon carbide particles is not necessary to be processed into a spherical shape or the like, and the metal-silicon carbide-based composite material can be obtained in stable cost.

Surface roughness of the composite part 2 can be reduced by reducing the amount of coarse particles contained in the metal-silicon carbide-based composite material, and it is possible to reduce surface roughness of the first surface layer 3a and the second surface layer 3b provided on the composite part 2 on a side opposite to the composite part 2. According to this, it is possible to expect an improvement of solder weldability onto the metal-silicon carbide-based composite material 1, a reduction in deviation of bending strength, and the like.

### [Measurement of Particle Size of Raw Material Silicon Carbide Powder]

A particle size of a raw material silicon carbide powder can be measured by a particle size distribution measurement device on the basis of a laser diffraction and scattering method described in JIS Z 8825: 2013 "Particle size analysis-Laser diffraction methods".

### [Measurement of Particle Size of Silicon Carbide in Composite Material]

A particle size of the silicon carbide particles constituting the silicon carbide-based porous body of the composite part 2 in the metal-silicon carbide-based composite material 1 is obtained as follows. First, the metal-silicon carbide-based composite material as a target is immersed in chemicals (for example, sodium hydroxide or the like) that dissolves only a metal part included in the metal-silicon carbide-based composite material to completely dissolve the metal part, and only the silicon carbide particles constituting the metal-silicon carbide-based composite material is recovered through filtration. A particle size of obtained particles can be measured by a particle size distribution measurement device on the basis of a laser diffraction and scattering method described in JIS Z 8825: 2013 "Particle size analysis-Laser diffraction methods".

### [Metal Component]

In the metal-silicon carbide-based composite material 1, the metal contains at least one kind selected from the group consisting of aluminum and magnesium. The metal in the metal-silicon carbide-based composite material 1 according to an embodiment of the present disclosure is a metal that contains one or more of aluminum and magnesium as a main component. As the metal, for example, pure aluminum composed of 99.8% by mass or greater of aluminum and unavoidable impurities, an aluminum alloy in which additive elements and the remainder are composed of aluminum and unavoidable impurities, pure magnesium composed of 99.8% by mass or greater of magnesium and unavoidable impurities, a magnesium alloy in which additive elements and the remainder are composed of magnesium and unavoidable impurities, and the like can be used. It is preferable that a melting point of the aluminum alloy and the magnesium alloy is as low as possible from the viewpoint of easy management of a molten metal at the time of infiltration. Examples of the alloy include an aluminum alloy containing 5% by mass to 25% by mass of silicon (Si). When using the aluminum alloy containing 5% by mass to 25% by mass of silicon, it is possible to obtain an effect of promoting densification of the metal-silicon carbide-based composite material.

For example, a total amount of aluminum and magnesium contained may be 60% by mass or greater, 65% by mass or greater, 70% by mass or greater, 75% by mass or greater, or 80% by mass or greater. In addition, the total amount of aluminum and magnesium contained may be, for example, 100% by mass. For example, the total amount may be less than 100% by mass, 99.8% by mass or less, 99.0% by mass or less, or 98.0% by mass or less. Note that, in a case where the metal contains an alloy, a total amount of aluminum and magnesium contained may be, for example, 98% by mass or less, 95% by mass or less, or 90% by mass or less.

Description will be given of the amount of aluminum contained in a case where aluminum is a main component. In this case, the amount of aluminum contained may be, for example, 60% by mass or greater, 65% by mass or greater, 70% by mass or greater, 75% by mass or greater, or 80% by mass or greater. In addition, since aluminum may be a pure product, the amount of aluminum contained may be, for example, 100% by mass. For example, the amount of aluminum contained may be less than 100% by mass, 99.8% by mass or less, 99.0% by mass or less, or 98.0% by mass or less. Note that, in a case where the metal contains an alloy, the amount of aluminum contained may be, for example, 98% by mass or less, 95% by mass or less, or 90% by mass or less.

Description will be given of the amount of magnesium contained in a case where magnesium is a main component. In this case, the amount of magnesium contained may be, for example, 60% by mass or greater, 65% by mass or greater, 70% by mass or greater, 75% by mass or greater, or 80% by mass or greater. In addition, since magnesium may be a pure product, the amount of magnesium contained may be, for example, 100% by mass. For example, the amount of magnesium contained may be less than 100% by mass, 99.8% by mass or less, 99.0% by mass or less, or 98.0% by mass or less. Note that, in a case where the metal contains an alloy, the amount of magnesium contained may be, for example, 98% by mass or less, 95% by mass or less, or 90% by mass or less.

In the case of using the aluminum alloy, since magnesium is contained in the alloy, coupling between the silicon carbide particles and the metal part becomes stronger, and thus this is preferable. The amount of magnesium contained in the aluminum alloy is preferably 0.2% by mass to 5.0% by mass. With regard to other components in the aluminum alloy or the magnesium alloy, a range thereof is not particularly limited as long as the other components are contained in a range in which characteristics of the alloy does not extremely vary, and for example, iron (Fe), copper (Cu), and the like may be contained.

### [Silica Sol]

The composite part 2 includes a silicon carbide-based porous body that is obtained by heating a mixture of the silicon carbide particles and silica sol. For example, the metal-silicon carbide-based composite material 1 according to an embodiment of the present disclosure may be prepared by a method of adding silica sol to a raw material silicon carbide powder so as to obtain a silicon carbide-based porous body with a high filling rate by a wet molding method. As the silica sol, a commercially available silica sol in which a solid content concentration is approximately 20% by mass can be used. With regard to a blending amount of the silica sol, with respect to 100 parts by mass of silicon carbide, approximately 0.5 parts by mass to 10 parts by mass in terms of the solid content concentration is sufficient, but the blending amount is preferably 1 part by mass to 5 parts by mass. When the blending amount of the silica sol is 0.5 parts by mass or greater, the strength of a green compact (silicon carbide-based porous body) that is obtained becomes sufficient even after baking. On the other hand, in a case where the blending amount of the silica sol is 10 parts by mass or less, a filling rate of silicon carbide in the green compact (silicon carbide-based porous body) that is obtained is high, and desired characteristics can be exhibited. In addition, the silica sol exists as a binder that connects silicon carbide particles in the silicon carbide-based porous body of the composite part 2.

### [Surface Layers (First Surface Layer 3a and Second Surface Layer 3b)]

In the metal-silicon carbide-based composite material 1, the first surface layer 3a and the second surface layer 3b which include a metal that contains one or more of aluminum and magnesium as a main component exist on both main surfaces of the composite part 2. In the case of being used as a heat sink of a semiconductor element, since the metal-silicon carbide-based composite material 1 has the above-described configuration, it is possible to expect an effect of improving adhesiveness in the case of performing a plating treatment on both surfaces of the composite material. In addition, since the metal-silicon carbide-based composite material 1 has the above-described configuration, it is possible to obtain an effect of improving surface roughness of the both surfaces of the composite material. The metal is a metal that contains one or more of aluminum and magnesium as a main component. As the metal, for example, pure aluminum composed of 99.8% by mass or greater of Al and unavoidable impurities, an aluminum alloy in which additive elements and the remainder are composed of Al and unavoidable impurities, pure magnesium composed of 99.8% by mass or greater of Mg and unavoidable impurities, a magnesium alloy in which additive elements and the remainder are composed of Mg and unavoidable impurities, and the like can be used.

For example, a total amount of aluminum and magnesium contained may be 60% by mass or greater, 65% by mass or greater, 70% by mass or greater, 75% by mass or greater, or 80% by mass or greater. In addition, the total amount of aluminum and magnesium contained may be, for example, 100% by mass. For example, the total amount may be less than 100% by mass, 99.8% by mass or less, 99.0% by mass or less, or 98.0% by mass or less. Note that, in a case where the metal contains an alloy, a total amount of aluminum and magnesium contained may be, for example, 98% by mass or less, 95% by mass or less, or 90% by mass or less.

Description will be given of the amount of aluminum contained in a case where aluminum is a main component. In this case, the amount of aluminum contained may be, for example, 60% by mass or greater, 65% by mass or greater, 70% by mass or greater, 75% by mass or greater, or 80% by mass or greater. In addition, since aluminum may be a pure product, the amount of aluminum contained may be, for example, 100% by mass. For example, the amount of aluminum contained may be less than 100% by mass, 99.8% by mass or less, 99.0% by mass or less, or 98.0% by mass or less. Note that, in a case where the metal contains an alloy, the amount of aluminum contained may be, for example, 98% by mass or less, 95% by mass or less, or 90% by mass or less.

Description will be given of the amount of magnesium contained in a case where magnesium is a main component. In this case, the amount of magnesium contained may be, for example, 60% by mass or greater, 65% by mass or greater, 70% by mass or greater, 75% by mass or greater, or 80% by mass or greater. In addition, since magnesium may be a pure product, the amount of magnesium contained may be, for example, 100% by mass. For example, the amount of magnesium contained may be less than 100% by mass, 99.8% by mass or less, 99.0% by mass or less, or 98.0% by mass or less. Note that, in a case where the metal contains an alloy, the amount of magnesium contained may be, for example, 98% by mass or less, 95% by mass or less, or 90% by mass or less.

Here, the surface layers (the first surface layer 3a and the second surface layer 3b) are formed from a material that includes a metal containing aluminum or magnesium in a similar manner as in the metal component, but may contain the other impurities and the like.

The thickness of the surface layers (the first surface layer 3a and the second surface layer 3b) is preferably 10 to 150 µm in an average thickness. When the thickness of each of the first surface layer 3a and the second surface layer 3b is 10 µm or greater in an average thickness, the silicon carbide particles are suppressed from being exposed to a composite material surface in the subsequent treatment, and target surface accuracy and adhesiveness of a plated layer can be secured. A lower limit value of the average thickness of each of the first surface layer 3a and the second surface layer 3b is preferably 40 µm or greater. For example, the lower limit value may be 50 µm or greater, 60 µm or greater, 70 µm or greater, or 80 µm or greater. An upper limit value of the average thickness of each of the first surface layer 3a and the second surface layer 3b is preferably 140 µm or less. For example, the upper limit value may be 130 µm or less or 120 µm or less.

The sum of the average thicknesses of the surface layers (the first surface layer 3a and the second surface layer 3b) on both surfaces is preferably 20% or less of the thickness of the metal-silicon carbide-based composite material 1. When an average thickness of the surface layers (an average thickness of the respective layers of the first surface layer 3a and the second surface layer 3b) is 150 µm or less, and the sum of the average thicknesses (the sum of the average thicknesses of the first surface layer 3a and the second surface layer 3b) is 20% or less of the thickness of the composite material, it is possible to obtain a metal-silicon carbide-based composite material having sufficient heat conductivity in addition to high surface accuracy and excellent adhesiveness of the plated layer.

A thickness difference between the first surface layer 3a and the second surface layer 3b which respectively cover both main surfaces of the composite part 2 is preferably 50 µm or less. When the thickness difference between the first surface layer 3a and the second surface layer 3b is 50 µm or less, even in a case where the metal-silicon carbide-based composite material is exposed to an environment in which a temperature variation is significant, a difference of a thermal stress that occurs due to a difference in a coefficient of thermal expansion between the surface layers (the first surface layer 3a and the second surface layer 3b) and the composite part 2 is small, and the amount of variation in bow that occurs due to a heat cycle decreases. According to this, it is possible to prevent a situation in which a gap occurs between the heat sink and the cooling fins and the heat radiation characteristics greatly decrease. The thickness difference between the first surface layer 3a and the second surface layer 3b is more preferably 45 µm or less, 40 µm or less, 35 µm or less, or 30 µm or less. It is preferable that the thickness difference between the first surface layer 3a and the second surface layer 3b is as small as possible, but may be 1 µm or greater or 3 µm or greater from the viewpoint of control easiness or the like.

Each of the surface layers (the first surface layer 3a and the second surface layer 3b) may be configured as a single layer, or may be a plurality of layers which further include a layer having a different metal composition, a layer containing ceramic fiber or the like other than a metal component, or the like. With regard to introduction of the surface layers (the first surface layer 3a and the second surface layer 3b), for example, when infiltrating the silicon carbide-based porous body with a metal component, metal foil or the like may be disposed between the silicon carbide-based porous body and a mold, which is used for infiltration, for compositing. Examples of the metal foil or the like include aluminum foil, magnesium foil, and a sheet constituted by ceramic fiber such as alumina fiber. In addition, after obtaining a composite material, the surface layers can be introduced by thermal spraying or cold spraying, attaching metal foil to the surfaces by hot pressing, or the like.

### [Measurement of Thickness of Surface Layers Covering Both Main Surfaces]

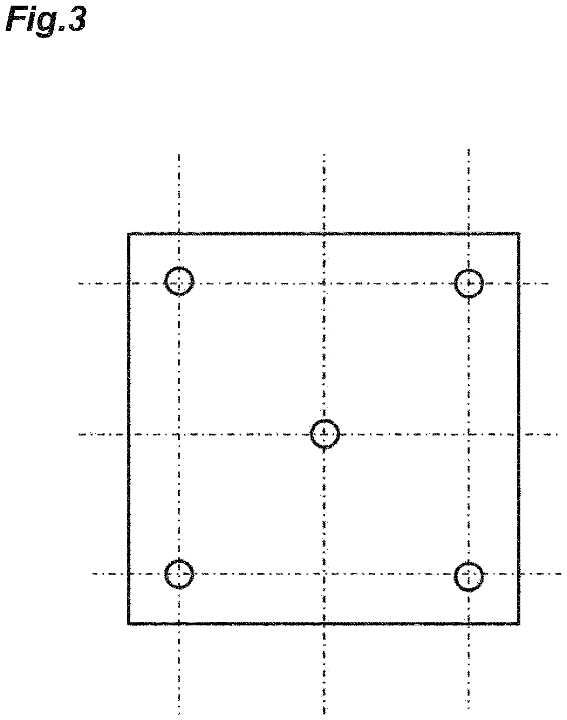

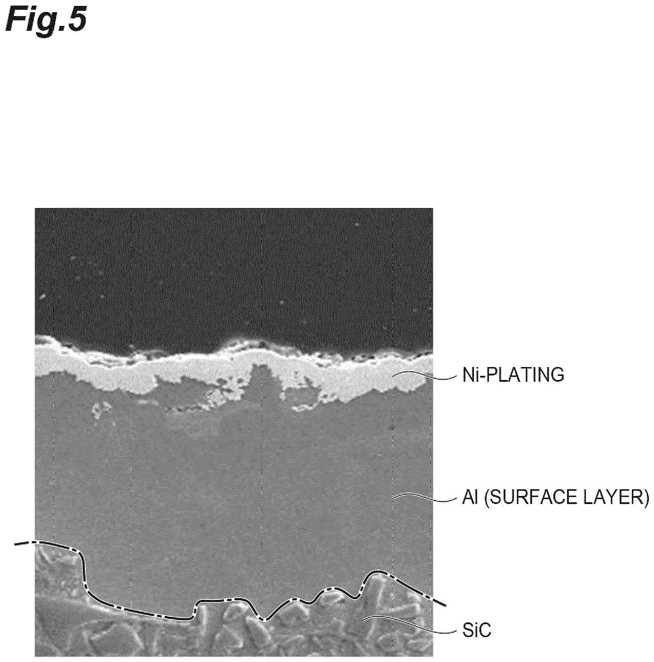

The thickness of the surface layers covering the both main surfaces in the metal-silicon carbide-based composite material is obtained as follows. The metal-silicon carbide-based composite material is cut by a diamond processing jig along straight lines passing through an inner side corresponding to 20% of the entire length of the composite material from end portions and middle lines of the composite material as indicated by dotted lines in FIG. 3. Then, at sites indicated by "O" in FIG. 3, surface portions (the first surface layer and the second surface layer) are observed with a scanning electron microscope at a magnification of 100 times. A distance from an outermost surface to the silicon carbide particles is measured at five sites with intervals of 200 µm, and an average of five points is calculated and is set as the thickness of the surface layers. Here, the surface layers are regions ranging from outermost surfaces of the both main surfaces to the silicon carbide particles (surfaces of silicon carbide-based composite material constituting the composite part) in a plate thickness direction (a boundary between the composite part 2 and each of the surface layers is set as a position where silicon carbide particles located on the outermost surface side among the silicon carbide particles constituting the composite part 2 are connected (refer to FIG. 2 and FIG. 5)). In addition, a thickness difference between the surface layers is obtained as an absolute value of a thickness difference between the surface layers on the both main surfaces which are obtained by the above-described method, that is, |(thickness of a surface layer (first surface layer) on a front main surface) - (thickness of a surface layer (second surface layer) on a rear main surface)| (µm).

In the metal-silicon carbide-based composite material of an embodiment of the present disclosure, heat conductivity of the metal-silicon carbide-based composite material can be set to 180 W/(m·K) or greater, and a coefficient of thermal expansion of the metal-silicon carbide-based composite material when being heated from room temperature to 150°C can be set to 9 ppm/K or less.

### [Bow of Metal-Silicon Carbide-Based Composite Material]

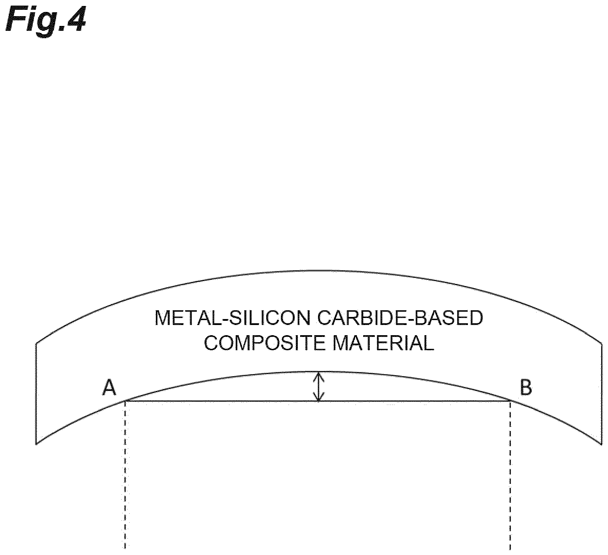

Bow of the metal-silicon carbide-based composite material is suppressed. The bow of the metal-silicon carbide-based composite material is obtained as follows. An arbitrary 10 cm length on a middle line on the main surfaces of the composite material is measured with a contact-type three-dimensional measuring device, and an initiation point is set as A and a termination point is set as B. A distance (arrow portion) to a maximum point with respect to a line segment AB in FIG. 4 is defined as the bow of the metal-silicon carbide-based composite material.

### [Variation in Bow of Metal-Silicon Carbide-Based Composite Material]

The amount of variation in bow when carrying out a heat cycle test with respect to the metal-silicon carbide-based composite material of the embodiment of the present disclosure can be set to ±50% or less. The amount of variation in bow when carrying out the heat cycle test is more preferably ±30% or less, and still more preferably ±20% or less. When the amount of variation in bow when carrying out the heat cycle test is within ±50%, in a case where the metal-silicon carbide-based composite material is used as a heat sink, even after undergoing the heat cycle, a gap is less likely to occur between the heat sink and cooling fins, and thus heat radiation characteristics can be prevented from deteriorating.

Conditions of the heat cycle test in this specification are set as follows. Specifically, a cycle of being exposed to a gas phase held at -40°C for 30 minutes and being exposed to a gas phase held at 125°C for 30 minutes is repeated 100 times. Here, the amount of variation in bow is [(the amount of bow after the heat cycle test) - (the amount of bow before the heat cycle test)]/(the amount of bow before the heat cycle test) × 100 (%).

The metal-silicon carbide composite material according to the present disclosure can reduce a thickness difference between the surface layers formed on the front and rear surfaces of the silicon carbide-based porous body. In the related art, since surface accuracy of the silicon carbide-based porous body has an influence on a thickness or surface roughness when being composited, facing processing is performed. However, since the silicon carbide particles are hard, and thus the facing processing results in processing through which silicon carbide particles on surfaces are excluded from the silicon carbide-based porous body. Accordingly, in a case where the silicon carbide-based porous body includes a lot of coarse particles, when performing the facing processing, unevenness on the surface after processing becomes large. Note that, in the composite material in the citation list, with regard to a particle size of the silicon carbide particles constituting the composite material, only an average particle size is defined, and coarse particles are not mentioned, and thus a thickness difference between the surface layers on the front and rear surfaces of the silicon carbide-based porous body is likely to occur.

In the silicon carbide particles constituting the composite part of the metal-silicon carbide-based composite material according to the present disclosure, the number of coarse particles is small. This represents that unevenness on the surface of the silicon carbide-based porous body obtained through the facing processing is reduced, and when the unevenness is reduced, the thickness difference between the surface layers formed on the front and rear surfaces of the silicon carbide-based porous body is reduced, and the amount of variation in bow at the time of the heat cycle can be reduced. Due to the operation, there are provided a metal-silicon carbide-based composite material in which the amount of variation in bow at the time of the heat cycle is small (bow stability is excellent), and a method capable of producing the metal-silicon carbide-based composite material at low cost.

### [Production Method]

Hereinafter, with regard to the metal-silicon carbide-based composite material according to the embodiment of the present disclosure, a production method by a molten metal forging method will be described as an example. However, the metal-silicon carbide-based composite material according to the present disclosure is not limited to only the production by the molten metal forging method.

Here, a method for producing the metal-silicon carbide-based composite material is roughly classified into two types including an infiltration method and a powder metallurgy method. In the two types, from the viewpoints of characteristics such as heat conductivity, the infiltration method is actually commercialized in many cases. The infiltration method includes various production methods, and there are a method performed at normal pressure and a high-pressure forging method performed under a high pressure. The high-pressure forging method includes a molten metal forging method and a die-casting method.

A method suitable for the embodiment of the present disclosure is the high-pressure forging method in which infiltration is performed under a high pressure, and the molten metal forging method is preferable to obtain a dense composite material excellent in characteristics such as heat conductivity. Typically, the molten metal forging method is a method in which a powder or a porous body such as ceramics is filled in a high-pressure container, and the powder or the porous body is infiltrated with the molten metal under a high temperature and a high pressure to obtain a composite material.

For example, the method for producing the composite material according to the embodiment of the present disclosure includes a raw material classification process, a molding process, a calcination process, a facing processing process, and an infiltration process. According to the method, mass production of the metal-silicon carbide-based composite material according to the present disclosure can be realized at low cost.

An embodiment of the method for producing the metal-silicon carbide-based composite material includes a classification process of classifying a silicon carbide powder to obtain a classified powder in which silicon carbide having a particle size of 300 µm or greater is 5% by volume or less, a molding process of pressure-molding a mixture prepared by mixing silica sol to the classified powder to obtain a green compact, a calcination process of heating the green compact to 800°C to 1100°C in the air or in an inert gas atmosphere to obtain a silicon carbide-based porous body, a facing processing process of performing facing processing on the silicon carbide-based porous body with a diamond processing jig, and an infiltration process of infiltrating the facing processed silicon carbide-based porous body with a molten metal and cooling the resultant silicon carbide-based porous body to form a composite part including the silicon carbide-based porous body and a metal that is infiltrated in the silicon carbide-based porous body, and first and second surface layers which contain a metal and coat both main surfaces of the composite part. Note that, a raw material classification process is an arbitrary process, and may be replaced with using of a silicon carbide powder in which silicon carbide having a particle size of 300 µm or greater is 5% by volume or less in advance.

### [Raw Material Classification Process]

Silicon carbide having a particle size of 300 µm or greater is set to 5% by volume or less by classifying the silicon carbide powder, thereby obtaining a classified powder. As a classification method, a known method such as a sieving net, gravitational field classification, inertial force field classification, and centrifugal force field classification can be used. Due to this process, silicon carbide particles suitable for the metal-silicon carbide-based composite material according to the embodiment of the present disclosure can be obtained.

### [Molding Process]

A predetermined amount of silica sol is added and mixed with the silicon carbide powder, and the resultant mixture is molded into a desired shape to obtain a green compact. As a molding method, dry press molding, wet press molding, extrusion molding, injection molding, and the like can be used.

### [Calcination Process]

The green compact obtained in the molding process is heated at a temperature of 800°C to 1100°C in the air or in an inert gas atmosphere to obtain a silicon carbide-based porous body. Examples of the inert gas include nitrogen. Facing processing can be carried out after undergoing the molding process and the calcination process.

### [Facing Processing Process]

As the facing processing method, a known method can be used, and examples thereof include milling processing. In addition, in the facing processing process, the thickness of the silicon carbide-based porous body can be adjusted by performing facing processing on the silicon carbide-based porous body by using a diamond processing jig. Due to this process, the metal-silicon carbide-based composite material when being composited can be adjusted to desired thickness and surface roughness.

### [infiltration Process]

The silicon carbide-based porous body that has undergone the facing processing is heated in advance to prevent cracking and the like due to thermal shock, is infiltrated with a molten metal composed of metal components heated at a temperature equal to or higher than a melting point at a high pressure, and is cooled, thereby forming a composite part including the silicon carbide-based porous body and a metal infiltrated to the silicon carbide-based porous body, and a first surface layer and a second surface layer which contain a metal and coat both main surfaces of the composite part. The first surface layer and the second surface layer may be metal layers composed of the metal components exude to the both main surfaces of the silicon carbide-based porous body, or a stacked body of a metal layer composed of the metal components and metal foil provided on the metal layer. In a case where the first surface layer and the second surface layer are set as the stacked body of the metal layer and the metal foil, the stacked body can be formed by providing the metal foil or the like on the both main surfaces of the silicon carbide-based porous body when being infiltrated with the molten metal composed of metal components at a high pressure in the infiltration process. The metal-silicon carbide-based composite material is obtained by the infiltration process. Due to the process, heat conductivity of the metal-silicon carbide-based composite material according to the present disclosure can be adjusted within a desired range.

### [Heat Radiation Component]

An embodiment of a heat radiation component includes the metal-silicon carbide-based composite material. For example, the heat radiation component can be prepared by mounting a ceramic circuit substrate or the like on the metal-silicon carbide-based composite material. In the mounting of the ceramic substrate or the like, for example, solder or the like may be used. In order to improve affinity for the solder or the like, Ni-plated layer may be provided on the metal-silicon carbide-based composite material. That is, the heat radiation component such as a heat sink for power modules can be obtained by carrying out an Ni-plating treatment on the surface of the metal-silicon carbide-based composite material according to the embodiment of the present disclosure, and by mounting a ceramic circuit substrate such as a silicon aluminum substrate and a silicon nitride substrate on the resultant surface through soldering or the like. In the heat radiation component, since the amount of variation in bow in the composite material is small even undergoing a heat cycle, cracking or peeling is suppressed between the metal-silicon carbide-based composite material and the ceramic circuit substrate, and thus the heat radiation component can be appropriately used as a heat radiation component even in an environment in which a temperature variation is severe.

Hereinbefore, description has been given of the metal-silicon carbide-based composite material according to the present disclosure, the heat radiation component using the same, and the production method therefor with reference to the embodiment of the invention, but the invention is not limited thereto.

### Examples

Hereinafter, the present disclosure will be described in more detail with reference to examples and comparative examples. However, the present disclosure is not limited to the following examples.

### [Examples 1 to 8, and Comparative Examples 1 and 2]

A commercially available high-purity silicon carbide powder was classified into a silicon carbide powder A (particle size: 300 µm or greater), a silicon carbide powder B (particle size: equal to or greater than 100 µm and less than 300 µm), a silicon carbide powder C (particle size: equal to or greater than 50 µm and less than 100 µm), a silicon carbide powder D (particle size: equal to or greater than 1 µm and less than 50 µm), and a silicon carbide powder E (particle size: less than 1 µm) were obtained. The particle size of each of the silicon carbide powders was measured by a particle size distribution measuring device (product name: "LS230", manufactured by Beckman Coulter, Inc., the same shall apply hereinafter) on the basis of a laser diffraction and scattering method described in JIS Z 8825: 2013 "Particle size analysis-Laser diffraction methods" (this particle size distribution corresponds to a particle size distribution of the silicon carbide particles constituting the silicon carbide-based porous body of the composite part).

The silicon carbide powders A to D obtained as described above were blended into a composition as shown in Table 1 to prepare a silicon carbide powder of which a particle size was adjusted (Examples 1 to 8, and Comparative Examples 1 and 2). 3% by mass of silica sol was added to the prepared silicon carbide powder, and the resultant mixture was mixed by stirring mixer for 30 minutes. The resultant mixture was molded at a pressure of 10 MPa to obtain a green compact having a shape of 100 mm × 100 mm × 6 mm.

**[Table 1]**

| | Blending of silicon carbide powder [% by volume] | | | | |
|---|---|---|---|---|---|
| | Silicon carbide powder A | Silicon carbide powder B | Silicon carbide powder C | Silicon carbide powder D | Silicon carbide powder E |
| | 300 µm or greater | Equal to or greater than 100 µm and less than 300 µm | Equal to or greater than 50 µm and less than 100 µm | Equal to or greater than 1 µm and less than 50 µm | Less than 1 µm |
| Example 1 | 0 | 25 | 0 | 75 | 0 |
| Example 2 | 0 | 50 | 0 | 50 | 0 |
| Example 3 | 0 | 75 | 0 | 25 | 0 |
| Example 4 | 1 | 74 | 0 | 25 | 0 |
| Example 5 | 3 | 72 | 0 | 25 | 0 |
| Example 6 | 5 | 15 | 10 | 65 | 5 |
| Example 7 | 5 | 40 | 10 | 40 | 5 |
| Example 8 | 5 | 65 | 10 | 15 | 5 |
| Comparative Example 1 | 6 | 65 | 5 | 20 | 4 |
| Comparative Example 2 | 10 | 45 | 5 | 30 | 10 |

The obtained green compact was heated at a temperature of 900°C for two hours in the air to obtain a silicon carbide-based porous body. Next, facing processing was carried out on both surfaces of the silicon carbide-based porous body by using a diamond processing jig to a thickness of 4.8 mm, and the resultant silicon carbide-based porous body was set as a sample. Note that, the thickness of the silicon carbide-based porous body after processing was confirmed by measuring the thickness of the central portion of the main surfaces by a micrometer. After preparing 10 sheets of samples, the 10 sheets of samples were partitioned with a stainless steel (SUS304) plate (releasing plate) applied with a releasing agent, an iron plate having a thickness of 12 mm was disposed on both ends of samples, and these members were fixed with a bolt of 10 mmφ and a nut to form one block.

Next, the block was preheated at a temperature of 600°C in an electric furnace. Then, the preheated block was placed in a press mold that was heated in advance and has a cavity having an inner size of 250 mmφ × 300 mm, a molten metal of an aluminum alloy, which has a composition containing 12% by mass of silicon, 1% by mass of magnesium, and the remainder composed of aluminum and unavoidable impurities and is held at a temperature of 800°C, was poured into the press mold, and the silicon carbide-based porous body was infiltrated with the aluminum alloy by pressing the press mold at a pressure of 60 MPa for 10 minutes, thereby obtaining a composite material. A metal ingot including the obtained composite material was cooled down to room temperature, was cut along a lateral surface shape of the releasing plate by using a wet band saw, and the sandwiching stainless steel plate was peeled off to obtain a composite material having dimensions of 100 mm × 100 mm × 5 mm.

The obtained metal-silicon carbide-based composite material was grinded to a test piece (3 mm × 4 mm × 20 mm) for measuring a coefficient of thermal expansion, and a test piece (25 mm (vertical) × 25 mm (horizontal) × 2 mm (thickness)) for measuring heat conductivity at room temperature by using a diamond processing jig. In addition, the metal-silicon carbide-based composite material was cut by the diamond processing jig along straight lines indicated by dotted lines in FIG. 3, that is, along straight lines passing through an inner side corresponding to 20% of the entire length (vertical or horizontal) of the composite material from end portions of the composite material, and middle lines on the main surface of the composite material.

After obtaining cut-out surface of the composite material, at magnification of 100 times at sites indicated by "O" in FIG. 3, surface portions (the first surface layer and the second surface layer) were observed with a scanning electron microscope. A distance from the outermost surface to the silicon carbide particles (a surface of silicon carbide-based composite material constituting the composite part) was measured at five sites with intervals of 200 µm, and an average value of five points was calculated and the value was set as the thickness of the surface layers. The obtained results are shown in Table 2.

As shown in Table 2, in the metal-silicon carbide-based composite material according to Examples 1 to 8, a thickness difference between a front surface (the first surface layer) and a rear surface (the second surface layer) was smaller in comparison to the metal-silicon carbide-based composite material according to Comparative Examples 1 and 2. In addition, it was confirmed that the region is constituted by a metal containing aluminum as a main component (component contained in the largest amount) through surface analysis using an energy dispersive X-ray analysis device.

A particle size of the silicon carbide particles contained in the obtained metal-silicon carbide-based composite material was obtained as follows with reference to Example 1. First, a metal-silicon carbide-based composite material that was grinded to a similar shape as in the test piece for measuring the heat conductivity at room temperature was prepared, and the metal-silicon carbide-based composite material was immersed in 20% sodium hydroxide aqueous solution to completely dissolve only components derived form a metal part and silica sol. Then, the silicon carbide particles were recovered through filtration. A particle size of the recovered silicon carbide particles was measured by a particle size distribution measuring device on the basis of a laser diffraction and scattering method described in JIS Z 8825: 2013 "Particle size analysis-Laser diffraction methods".

A histogram was created at a pitch of 5 µm from the obtained measurement results, and two peaks separated with an interval of 50 µm or greater were confirmed. At this time, it was confirmed that in a peak on a small particle size side, the particle size enters a range of equal to or greater than 1 µm and less than 50 µm, and in a peak on a large particle size side, the particle size enters a range of equal to or greater than 100 µm and less than 300 µm. In addition, a peak area ratio between the peak on a small particle size side and the peak on a large particle size side was approximately 25 : 75.

**[Table 2]**

| | Average thickness [µm] | | Thickness difference [µm] |
|---|---|---|---|
| | First surface layer | Second surface layer | |
| Example 1 | 100 | 90 | 10 |
| Example 2 | 100 | 112 | 12 |
| Example 3 | 90 | 101 | 11 |
| Example 4 | 85 | 100 | 15 |
| Example 5 | 110 | 103 | 7 |
| Example 6 | 109 | 80 | 29 |
| Example 7 | 102 | 80 | 22 |
| Example 8 | 90 | 115 | 25 |
| Comparative Example 1 | 149 | 82 | 67 |
| Comparative Example 2 | 92 | 180 | 88 |

Next, with respect to the respective test pieces, a coefficient of thermal expansion, heat conductivity, a volume fraction rate of silicon carbide particles, a density, the amount of bow, and the amount of variation in bow were measured in accordance with the following method.

### <Coefficient of Thermal Expansion and Heat Conductivity>

Measurement of a coefficient of thermal expansion from room temperature to 150°C by a thermal expansion meter and measurement of heat conductivity at room temperature by a laser flash method were performed on the respective test pieces. The obtained results are shown in Table 3.

### <Volume Fraction Rate of Silicon Carbide Particles and Density>

A density of each test piece was measured by using the test piece for measuring heat conductivity in accordance with an Archimedes method, and a volume fraction rate of the silicon carbide particles was calculated from a value of the density. The obtained results are shown in Table 3.

### <Amount of Bow, and Amount of Variation in Bow After Heat Cycle Test>

In addition, an arbitrary 10 cm length on a middle line on the main surfaces of each test piece was measured with a contact-type three-dimensional measuring device (product name: CONTOURECORD 1600D, manufactured by TOKYO SEIMITSU CO., LTD., the same shall apply hereinafter), and an initiation point was set as A and a termination point was set as B. A distance (distance indicated by an arrow in FIG. 4) to a maximum point with respect to a line segment AB was defined as the amount of bow of the metal-silicon carbide-based composite material. The obtained results are shown in Table 3.

In addition, a heat cycle test was carried out 100 times at a temperature range of -40°C to 125°C by using the metal-silicon carbide-based composite materials. Note that, one cycle was carried out in a state in which end points were maintained at -40°C and 125°C for 30 minutes, respectively. Then, the amount of bow with respect to a length of 10 cm on the main surfaces of the composite material was measured by using a contact-type three-dimensional measuring device, and the amount of variation in the amount of bow (the amount of variation in bow) with respect to an initial value was calculated. At this time, the amount of variation in bow was set to [(the amount of bow after the heat cycle test) - (the amount of bow before the heat cycle test)]/(the amount of bow before the heat cycle test) × 100. The obtained results are shown in Table 3.

**[Table 3]**

| | Coefficient of thermal expansion [ppm/K] | Heat conductivity [W/m·K] | Volume fraction rate of silicon carbide particles [% by volume] | Density [g/cm³] | Amount of bow^{∗1} [µm] | Amount of variation in bow^{∗2} [%] |
|---|---|---|---|---|---|---|
| Example 1 | 7.2 | 200 | 65 | 3.04 | 48 | 5 |
| Example 2 | 7.2 | 213 | 65 | 3.04 | 38 | -7 |
| Example 3 | 7.2 | 199 | 64 | 3.03 | 66 | -4 |
| Example 4 | 7.2 | 200 | 64 | 3.03 | 70 | -5 |
| Example 5 | 7.3 | 206 | 64 | 3.03 | 58 | 3 |
| Example 6 | 7.2 | 191 | 65 | 3.04 | 59 | 12 |
| Example 7 | 7.3 | 216 | 63 | 3.03 | 34 | 15 |
| Example 8 | 7.2 | 200 | 64 | 3.03 | 49 | -12 |
| Comparative Example 1 | 6.9 | 184 | 62 | 3.02 | 124 | 51 |
| Comparative Example 2 | 6.8 | 209 | 58 | 3.00 | 151 | -55 |

| | | | | | | |
|---|---|---|---|---|---|---|
| 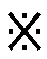 1: The amount of bow with respect to a sample length of 10 cm 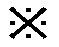 2: The amount of variation in bow after a heat cycle of -40°C ⇔ 125°C (each, 30 minutes) × 100 cycles | | | | | | |

As shown in Table 3, in the metal-silicon carbide-based composite materials according to Examples 1 to 8, even after carrying out the heat cycle test, the amount of variation in bow was smaller, the coefficient of thermal expansion was lower, and the heat conductivity was higher in comparison to the metal-silicon carbide-based composite materials according to Comparative Examples 1 and 2.

In contrast, in the metal-silicon carbide-based composite materials according to Comparative Examples 1 and 2, an absolute value of the amount of variation in bow after carrying out the heat cycle test exceeded 50%. It is considered that this is because the silicon carbide powder having a particle size of 300 µm or greater was contained in 5% by volume or greater.

### [Example 9]

In Example 9, A metal-silicon carbide-based composite material was produced in a similar manner as in Example 3 except that the infiltrated metal was changed to commercially available pure magnesium in which magnesium was 99.8% by mass or greater and the remainder was unavoidable impurities. In the obtained metal-silicon carbide-based composite material, an average thickness of a front surface (first surface layer) was 90 µm, an average thickness of a rear surface (second surface layer) was 98 µm, and a thickness difference was 8 µm.

In addition, with respect to the obtained metal-silicon carbide-based composite material, the coefficient of thermal expansion, the heat conductivity, the volume fraction rate of the silicon carbide particles, the density, the amount of bow, and the amount of variation in bow were measured in a similar manner as in Example 1. The coefficient of thermal expansion was 7.5 ppm/K, the heat conductivity was 197 W/(m·K), the volume fraction rate of the silicon carbide particles was 65% by volume, the density was 2.69 g/cm³, the amount of bow with respect to the main surface length of 10 cm in the composite material was 46 µm, and the amount of variation in bow was 8%. That is, even when using a metal containing magnesium as a main component as the infiltrated metal, a similar result as in the case of using the metal containing aluminum as a main component was obtained.

### [Examples 10 and 11]

Metal-silicon carbide-based composite materials were produced in a similar manner as in Example 3 except that a metal plate was disposed between the silicon carbide-based porous body and the stainless steel plate when partitioning the ten pieces of samples with the stainless steel (SUS304) plate applied with the releasing agent. Note that, in the size of the metal plate, a length was set to 100 mm, a width was set to 100 mm, and the thickness was set to 50 µm. Materials of the disposed metal plate and the infiltrated molten metal are shown in Table 4.

With respect to the obtained metal-silicon carbide-based composite materials, an average thickness of a front surface (first surface layer), an average thickness of a rear surface (second surface layer), and a thickness difference were measured. Results are shown in Table 5. In addition, with respect to the metal-silicon carbide-based composite materials, a coefficient of thermal expansion from room temperature to 150°C, a heat conductivity at room temperature, a volume fraction rate of the silicon carbide particles, a density, the amount of bow with respect to a main surface length of 10 cm in the composite materials, and the amount of variation in bow were measured. Results are shown Table 6.

**[Table 4]**

| | Material of metal plate | Metal infiltrated |
|---|---|---|
| Example 10 | Mg | Al |
| Example 11 | Al | Mg |

**[Table 5]**

| | Average thickness [µm] | | Thickness difference [µm] |
|---|---|---|---|
| | First surface layer | Second surface layer | |
| Example 10 | 98 | 90 | 8 |
| Example 11 | 80 | 95 | 15 |

**[Table 6]**

| | Coefficient of thermal expansion [ppm/K] | Heat conductivity [W/m·K] | SiC volume fraction rate [% by volume] | Density [g/cm³] | Amount of bow^{∗1} [µm] | Amount of variation in bow^{∗2} [%] |
|---|---|---|---|---|---|---|
| Example 10 | 7.2 | 197 | 64 | 3.03 | 71 | 3 |
| Example 11 | 7.3 | 189 | 65 | 3.04 | 42 | -8 |

As shown in Table 4 to Table 6, even in the case of producing the metal-silicon carbide-based composite material by using the infiltrated metal, and the metal plate of a metal different from the infiltrated metal, metal-silicon carbide-based composite materials in which a thickness difference between the front surface and the rear surface was small in a similar manner as in Examples 1 to 8 were obtained. In addition, it was confirmed that the metal-silicon carbide-based composite materials have a low coefficient of thermal expansion and high heat conductivity, and the amount of variation in bow is small even after carrying out the heat cycle test.

### [Example 12]

The metal-silicon carbide-based composite material produced in Example 2 was subjected to an electroless Ni plating treatment to further form a plated layer having a thickness of 5 µm on the surface of the composite material, and the composite material was set as a new metal-silicon carbide-based composite material. A solder paste having a thickness of 100 µm was screen-printed on the surface of the plated composite material. A commercially available aluminum nitride substrate was placed on a printed surface of the solder paste, and was heated in a reflow furnace at a temperature of 300°C for five minutes to bond a ceramic circuit substrate to the surface of the plated composite material through solder.

### [Example 13]

The ceramic circuit substrate was bonded in a similar manner as in Example 12 except that a commercially available silicon nitride substrate was used instead of the aluminum nitride substrate.

### [Comparative Example 3]

The ceramic circuit substrate was bonded in a similar manner as in Example 12 except that a copper plate was used instead of the metal-silicon carbide-based composite material.

A heat cycle test was carried out 1000 times in a temperature range of -40°C to 125°C by using a composite material to which each of the ceramic circuit substrates prepared in Examples 12 and 13, and Comparative Example 3 was bonded. Note that, one cycle was carried out in a state in which end points were maintained at -40°C and 125°C for 30 minutes, respectively. In the composite materials of Examples 12 and 13, even after the heat cycle test, cracking or peeling were not observed between the metal-silicon carbide-based composite material and the ceramic circuit substrate, and exhibited reliability suitable for a heat radiation component. On the other hand, in Comparative Example 3, cracking occurred between the copper plate and the ceramic circuit substrate after 30 heat cycles.

### Reference Signs List

1: metal-silicon carbide-based composite material, 2: composite part, 3a: surface layer (first surface layer), 3b: surface layer (second surface layer).

## Claims

1. A metal-silicon carbide-based composite material (1) comprising:
a composite part (2) including a silicon carbide-based porous body constituted by a plurality of silicon carbide particles, and a metal that is infiltrated in the silicon carbide-based porous body; and
first and second surface layers (3a, 3b) which contain a metal and coat both main surfaces of the composite part (2),
wherein the metal contains at least one kind selected from the group consisting of aluminum and magnesium,
**characterized in that**
the amount of particles having a particle size of 300 µm or more in the plurality of silicon carbide particles is 5% by volume or less.

2. The metal-silicon carbide-based composite material (1) according to claim 1,
wherein a difference between the thickness of the first surface layer (3a) and the thickness of the second surface layer (3b) is 50 µm or less.

3. The metal-silicon carbide-based composite material (1) according to claim 1 or 2,
wherein the amount of variation in bow when performing a heat cycle test is ±50% or less.

4. A method for producing the metal-silicon carbide-based composite material (1) according to any one of claims 1 to 3, the method comprising:
a classification process of classifying a silicon carbide powder to obtain a classified powder in which silicon carbide having a particle size of 300 µm or more is 5% by volume or less;
a molding process of pressure-molding a mixture prepared by mixing silica sol to the classified powder to obtain a green compact;
a calcination process of heating the green compact at 800°C to 1100°C in the air or in an inert gas atmosphere to obtain a silicon carbide-based porous body;
a facing processing process of performing facing processing on the silicon carbide-based porous body with a diamond processing jig; and
an infiltration process of infiltrating the silicon carbide-based porous body that is facing-processed with a molten metal, and cooling the resultant silicon carbide-based porous body to obtain a metal-silicon carbide-based composite material.

5. A heat radiation component comprising:
the metal-silicon carbide-based composite material (1) according to any one of claims 1 to 3.

## Patentansprüche

1. Verbundwerkstoff auf der Basis von Metall-Siliciumcarbid (1), umfassend:
einen Verbundstoffteil (2), der einen porösen Körper auf der Basis von Siliciumcarbid, der durch eine Mehrzahl von Siliciumcarbidpartikeln gebildet wird, und ein Metall, das in den porösen Körper auf der Basis von Siliciumcarbid eingebracht ist, umfasst; und
eine erste und eine zweite Oberflächenschicht (3a, 3b), die ein Metall enthalten und beide Hauptflächen des Verbundstoffteils (2) bedecken,
wobei das Metall wenigstens eine Art enthält, die ausgewählt aus der Gruppe bestehend aus Aluminium und Magnesium,
**dadurch gekennzeichnet, dass**
die Menge an Partikeln mit einer Partikelgröße von 300 µm oder mehr in der Mehrzahl von Siliciumcarbidpartikeln 5 Vol.-% oder weniger beträgt.

2. Verbundwerkstoff auf der Basis von Metall-Siliciumcarbid (1) nach Anspruch 1,
wobei ein Unterschied zwischen der Dicke der ersten Oberflächenschicht (3a) und der Dicke der zweiten Oberflächenschicht (3b) 50 µm oder weniger beträgt.

3. Verbundwerkstoff auf der Basis von Metall-Siliciumcarbid (1) nach Anspruch 1 oder 2,
wobei das Maß der Biegungsabweichung beim Durchführen eines Wärmezyklustests ±50 % oder weniger beträgt.

4. Verfahren zur Herstellung des Verbundwerkstoffs auf der Basis von Metall-Siliciumcarbid (1) nach einem der Ansprüche 1 bis 3, wobei das Verfahren umfasst:
einen Klassierungsprozess des Klassierens eines Siliciumcarbidpulvers, um ein klassiertes Pulver zu erhalten, in dem Siliciumcarbid mit einer Partikelgröße von 300 µm oder mehr 5 Vol.-% oder weniger ausmacht;
einen Formungsprozess des Druckformens eines Gemischs, hergestellt durch Zumischen von Siliciumdioxid-Sol zu dem klassierten Pulver, um einen Grünling zu erhalten;
einen Brennprozess des Erhitzens des Grünlings bei 800 °C bis 1100 °C in Luft oder in einer Inertgasatmosphäre, um einen porösen Körper auf der Basis von Siliciumcarbid zu erhalten;
einen Oberflächenbearbeitungsprozess des Durchführens einer Oberflächenbearbeitung an dem porösen Körper auf der Basis von Siliciumcarbid mit einer Diamant-Bearbeitungsvorrichtung; und
einen Einbringprozess des Einbringens eines geschmolzenen Metalls in den porösen Körper auf der Basis von Siliciumcarbid, der oberflächenbearbeitet ist, und Kühlens des resultierenden porösen Körpers auf der Basis von Siliciumcarbid, um einen Verbundwerkstoff auf der Basis von Metall-Siliciumcarbid zu erhalten.

5. Wärmeabstrahlkomponente, umfassend:
den Verbundwerkstoff auf der Basis von Metall-Siliciumcarbid (1) nach einem der Ansprüche 1 bis 3.

## Revendications

1. Matériau composite à base de métal et de carbure de silicium (1) comprenant :
une partie composite (2) incluant un corps poreux à base de carbure de silicium constitué par une pluralité de particules de carbure de silicium, et un métal qui est infiltré dans le corps poreux à base de carbure de silicium ; et
des première et deuxième couches de surface (3a, 3b) qui contiennent un métal et revêtent les deux surfaces principales de la partie composite (2),
dans lequel le métal contient au moins un type choisi dans le groupe constitué par l'aluminium et le magnésium,
**caractérisé en ce que**
la quantité de particules ayant une taille de particule de 300 µm ou plus dans la pluralité de particules de carbure de silicium est de 5 % en volume ou moins.

2. Matériau composite à base de métal et de carbure de silicium (1) selon la revendication 1,
dans lequel une différence entre l'épaisseur de la première couche de surface (3a) et l'épaisseur de la deuxième couche de surface (3b) est de 50 µm ou moins.

3. Matériau composite à base de métal et de carbure de silicium (1) selon la revendication 1 ou 2,
dans lequel la quantité de variation de l'arc lors de la réalisation d'un test de cycle thermique est de ± 50 % ou moins.

4. Procédé de production du matériau composite à base de métal et de carbure de silicium (1) selon l'une quelconque des revendications 1 à 3, le procédé comprenant :
un processus de classification consistant à classifier une poudre de carbure de silicium pour obtenir une poudre classifiée dans laquelle le carbure de silicium ayant une taille de particule de 300 µm ou plus est de 5 % en volume ou moins ;
un processus de moulage consistant à mouler sous pression un mélange préparé en mélangeant un sol de silice à la poudre classifiée pour obtenir un compact vert ;
un processus de calcination consistant à chauffer le compact vert à 800 °C à 1 100 °C dans l'air ou dans une atmosphère de gaz inerte pour obtenir un corps poreux à base de carbure de silicium ;
un processus de traitement de surfaçage consistant à effectuer un traitement de surfaçage sur le corps poreux à base de carbure de silicium avec un gabarit de traitement en diamant ; et
un processus d'infiltration consistant à infiltrer le corps poreux à base de carbure de silicium qui a subi un traitement de surfaçage avec un métal fondu, et à refroidir le corps poreux à base de carbure de silicium résultant pour obtenir un matériau composite à base de métal et de carbure de silicium.

5. Composant pour rayonnement thermique comprenant :
le matériau composite à base de métal et de carbure de silicium (1) selon l'une quelconque des revendications 1 à 3.
